# EUROPEAN PATENT SPECIFICATION

(11) **EP 0 388 918 B1**
(45) Date of publication and mention of the grant of the patent: **28.08.1996**
(21) Application number: 90105339.7
(22) Date of filing: 21.03.1990
(51) Int. Cl.: G05F 3/20

(54) **Semiconductor integrated circuit having a substrate potential detecting circuit**
Integrierte Halbleiterschaltung mit einer Substratspannungsdetektorschaltung
Circuit intégré à semi-conducteur avec circuit détecteur de tension du substrat

(30) Priority: 22.03.1989 JP 69826/89
(43) Date of publication of application: 26.09.1990
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Koyanagi, Masaru, c/o Intellectual Property Div., Minato-ku Tokyo 105 (JP); Yamada, Minoru, c/o Intellectual Property Div., Minato-ku Tokyo 105 (JP)
(74) Representative: Lehn, Werner, Dipl.-Ing.

(56) References cited:
- EP-A- 0 217 065
- EP-A- 0 262 357
- EP-A- 0 293 045
- WO-A-84/03185

## Description

This invention relates to a semiconductor integrated circuit, and more particularly to a substrate potential controlling circuit used in a semiconductor integrated circuit.

A semiconductor integrated circuit generally includes a substrate potential controlling circuit for reducing current consumption caused by operation of a substrate potential generating circuit itself.

In general, such a substrate potential controlling circuit includes a substrate potential generating circuit for generating a substrate potential, a substrate potential detecting circuit for detecting the substrate potential, and a switching circuit for ON-OFF controlling the operation of the substrate potential generating circuit according to the output of the substrate potential detecting circuit. With the substrate potential controlling circuit, when the substrate potential is lowered and reaches a preset level, the substrate potential detecting circuit detects that the substrate potential is set to the preset value and supplies a detection output to the switching circuit. The switching circuit interrupts the operation of the substrate potential generating circuit in response to the detection output. In this way, the substrate potential generating circuit will not consume any current if the substrate potential is set below the threshold value of the substrate potential detection circuit. The substrate potential controlling circuit can keep the substrate potential at a constant level without increasing the current consumption by use of the above feedback loop.

The above substrate potential controlling circuit has a defect that the substrate potential cannot be controlled at a sufficiently high speed in response to variations in the power source voltage. Therefore, a substrate potential controlling circuit which can control the substrate potential irrespective of variations in the power source voltage has been developed. Such a circuit is disclosed in U.S. Patent No. 4,794,278 (Inventor: Branislav, Vajdic, Applicant: Intel Corporation, Patented Date: Dec. 27th, 1988). The substrate potential controlling circuit disclosed in the above U.S. Patent includes first and second level detectors. The first level detector detects a substrate voltage less negative than a preset value. At this time, it supplies charges by use of the charge pump to force the substrate to a more negative voltage level. When the substrate voltage exceeds the threshold value, the charge supply is interrupted. The second level detector becomes operative when the substrate voltage has exceeded a preset limit level which lies on the negative side with respect to the threshold value. At this time, a clamper is operated to clamp the substrate voltage.

However, if the second detector is provided as described above, the total power consumption is increased by the power consumption of the second detector and therefore it is impossible to use the second detector in a device which requires a low power consumption. Further, since the detection circuit is separately disposed, the substrate potential may not be precisely controlled if the characteristics of detection elements are not constant.

EP-A-0217065 shows a substrate potential generating circuit connected to the substrate via a switch, the switch being controlled by a substrate contact. EP-A-0262357 shows a similar circuit with a delay element in the switch control circuit. This document shows the features of the preamble of claim 1. WO 84/03185 shows a substrate bias control circuit with means for coupling a bias voltage to the substrate or connecting the supply voltage to the substrate when the bias is not present.

JP-A-62-190746 shows a substrate bias voltage generating circuit including the features of the preamble of claim 1. In this circuit the substrate potential generating circuit will be turned on if the substrate potential becomes higher than a predetermined voltage and the substrate potential leak circuit will be turned on if the substrate potential becomes equal or lower than the same predetermined voltage. Furthermore, due to the use of an N-channel transistor in the substrate potential leak circuit for stopping supplying the charges into the substrate on the basis of the detection output of the substrate potential detecting circuit there will be an undesired current flow to the substrate even during the operating period of the substrate potential generating circuit. So the power consumption will be increased.

Accordingly, an object of this invention is to provide a semiconductor integrated circuit which has an improved ability of the substrate potential to follow variations in the power source voltage with a minimum power consumption.

According to the present invention there is provided a semiconductor integrated circuit having a substrate potential control function and comprising: a substrate potential generating circuit; a substrate potential detection circuit for sensing a substrate potential; a switch circuit for turning on or off the substrate potential generating circuit on the basis of a detection output of the substrate potential detection circuit; and a substrate potential leak circuit , characterized in that said substrate potential leak circuit supplies charges into the substrate to raise the substrate potential when the substrate potential becomes lower than an operating level of the substrate potential generating circuit by a predetermined voltage, and stops supplying the charges into the substrate when the substrate potential becomes slightly lower than the operating level of the substrate potential generating circuit; and said substrate potential leak circuit includes a P-channel transistor having a gate controlled in accordance with an output of the substrate potential detection circuit, said P-channel transistor having a current path whose one end is connected to a leak source used for raising the substrate potential.

Preferably, said substrate potential leak circuit further includes inverter means for shaping a waveform of an output of the substrate potential detection cicuit, the gate of the P-channel transistor being controlled in accordance with an output of the inverter means.

Expediently, said substrate potential leak further includes a N-channel transistor having a gate connected to a ground-potential node, said N-channel transistor having a current path inserted between the substrate and another end of the current path of the first P-channel transistor.

Further features of the invention are apparent from dependent claims 4 to 13.

This invention can be more fully understood from the following detailed description when taken in conjunction with the accompanying drawings, in which
Fig. 1 is a digram showing general circuit construction of a substrate potential controlling circuit;
Fig. 2 is a digram showing the dependency of the substrate potential on the power source voltage in the circuit of Fig. 1;
Figs. 3A to 3C are waveform diagrams showing variation in the substrate voltage with respect to various variations in the power source voltage;
Figs. 4A and 4B are diagrams of resistor and diode circuits for improving the dependency of the substrate voltage on the power source foltage in the circuit of Fig. 1;
Fig. 5 is a diagram showing the dependency on the power source voltage of Fig. 2 in comparison with the dependency of the substrate voltage on the power source voltage obtained when the circuit of Fig. 4 is connected;
Fig. 6 is a diagram showing the circuit construction of one embodiment of a semiconductor integrated circuit of this invention;
Fig. 7 is a diagram showing the circuit construction of another embodiment of a semiconductor integrated circuit of this invention;
Fig. 8 is a diagram showing the circuit construction of still another embodiment of a semiconductor integrated circuit of this invention;
Fig. 9 is a waveform diagram for illustrating the dependency of the substrate potential on the power source voltage drop with reference to the voltage and current waveforms on respective nodes in the circuit of Fig. 6;
Fig. 10 is a waveform diagram for illustrating the dependency of the substrate potential on the power source voltage drop with reference to the voltage and current waveforms on the respective nodes in the circuits of Figs. 7a and 8;
Fig. 11 is a waveform diagram for illustrating the dependency of the substrate potential on the power source voltage drop with reference to the voltage and current waveforms on the respective nodes in the conventional substrate voltage controlling circuit;
Fig. 12 is a diagram of a diode circuit which may be connected to the circuit of this invention so as to change the dependency of the substrate potential on the power source voltage; and
Fig. 13 is a diagram showing the dependency of the substrate potential on the power source voltage in the circuit of this invention shown in Figs. 6 to 8 in comparison with the dependency of the substrate potential on the power source voltage obtained when the circuit of Fig. 12 is connected.

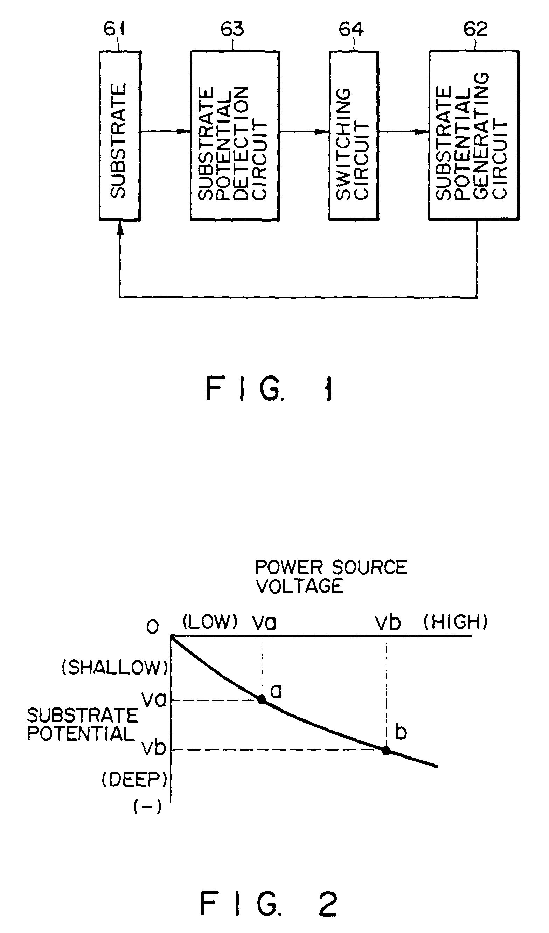

As is schematically shown in Fig. 1, a substrate potential controlling circuit includes a substrate potential generating circuit 62 for generating a potential of a substrate 61, a substrate potential detection circuit 63 for detecting the potential of the substrate 61, and a switching circuit 64 for ON-OFF controlling the operation of the substrate potential generating circuit 62 according to the output of the substrate potential detection circuit 63.

With this substrate potential controlling circuit, when the substrate potential is lowered and reaches a preset value, the substrate potential detecting circuit 63 is made operative and the switching circuit 64 interrupts the operation of the substrate potential generating circuit 62 so that the substrate potential generating circuit 63 itself will not consume any current until the substrate potential exceeds the threshold value of the substrate potential detection circuit 63.

Also, even in a case where the operation of the circuit arranged on a chip of the semiconductor integrated circuit is frequently effected so as to permit a large amount of substrate current flow or in a case where the operation of the circuit inside the chip is not frequently effected so as to permit only a small amount of substrate current flow, the substrate potential can be kept at a constant value by the operation of the substrate potential detection circuit 63. With the above substrate potential controlling circuit, the dependency of the substrate potential on the Vcc power source voltage as shown in Fig. 2 can be obtained. That is, the substrate potential generally becomes negatively deeper as the Vcc power source voltage becomes higher.

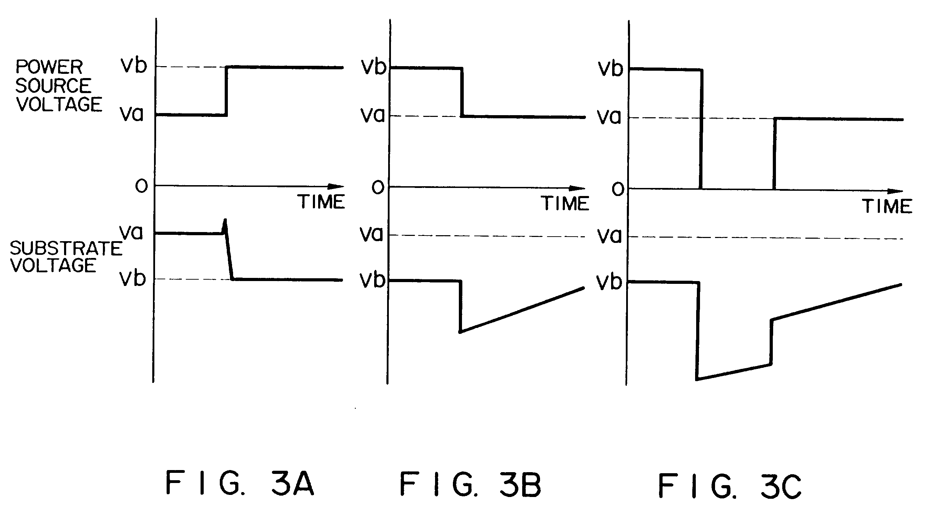

Figs. 3A to 3C are diagrams showing the characteristic of the substrate potential to follow the power source voltage when the power source voltage has varied.

Fig. 3A shows variation in the substrate potential when the power source voltage rises from Va to Vb. In this case, since the substrate potential detection circuit 63 detects that the substrate potential is not sufficiently deep, the substrate potential generating circuit 62 is set operative and the substrate potential reaches the preset level determined by the substrate potential detection circuit 63 at a relatively high speed. After this, the substrate potential is kept at a constant level, and no particular problem will occur.

In contrast, when the power source voltage is lowered from Vb to Va as shown in Fig. 3B, the substrate potential is lowered in synchronism with the power source voltage because of coupling with the node inside the chip. After this, the substrate potential rises, but no substantial component for pulling up the substrate potential in a positive direction exists inside the chip. That is, only a small amount of current such as junction leak current and leak current in the substrate potential detection circuit 63 may exist as the above component. For this reason, it takes an extremely long time for the substrate potential (corresponding to the power source voltage) to reach a normal level.

At this time, since the substrate potential detection circuit 63 sets the substrate potential generating circuit 62 non-operative since the substrate potential (corresponding to the power source voltage) is deeper than the normal level. Therefore, in the operation immediately after the power source voltage has been lowered, the depletion layer in the PN junction becomes wider since the substrate potential is significantly deeper than in the normal operation. As a result, the threshold voltage of the transistor increases and the operation becomes extremely unstable. As shown in Fig. 3C, the same problem occurs when the power source voltage is once completely turned off and then immediately turned on.

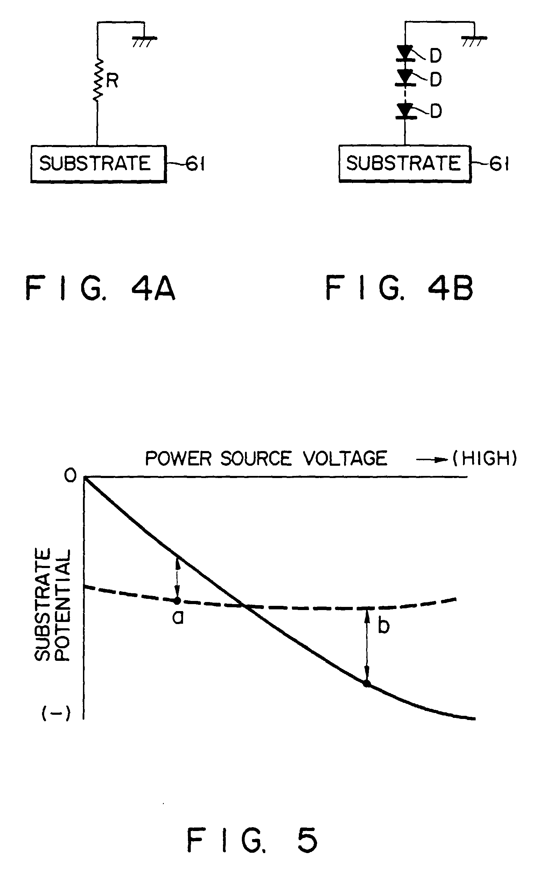

As a countermeasure for the above problem, a method can be considered in which the substrate 61 is connected to a ground node via a high resistance resistor R so as to set the substrate to a ground potential by a leak current as shown in Fig. 4A or the substrate 61 is connected to the ground node via series-connected diodes D so as to set the substrate to a certain voltage by a leak current flowing into the ground node as shown in Fig. 4B.

However, since a current always flows from the ground node to the substrate 61 in the circuit shown in Fig. 4A, current consumption becomes larger. Further, since the resistance of the high resistance resistor R is limited, a large leak current cannot flow in the resistor and it is impossible to set the substrate potential to the ground potential.

Since the substrate potential is held at a substantially constant level in the circuit of Fig. 4B, the dependency characteristic of the circuit becomes different from the dependency of the substrate potential on the power source voltage shown in Fig. 2 as shown by broken lines in Fig. 5. The solid line in Fig. 5 indicates the same dependency of the substrate potential on the power source voltage as shown in Fig. 2. As is clearly seen from the characteristic indicated by the broken lines, the degree of leak of the substrate potential or the degree of variations in the substrate potential towards the ground potential is insufficient in a low power source voltage range as is indicated by a, for example, and the substrate potential is excessively leaked to a shallower level with respect to the detection level of the substrate potential detection circuit 63 in a high power source voltage range as is indicated by b, for example. Therefore, the current consumption increases, and this method is not effective to solve the above problem.

This invention is made to solve a problem that, in a case where the power source voltage drops or the power source voltage is once set to the OFF level and then immediately set to the ON level, the substrate potential is significantly deeper in the circuit operation effected immediately after the power source voltage drop or immediately after the power source voltage is set to the OFF level than in the normal operation and the circuit operation becomes unstable with increase in the threshold voltage of the transistor and may be erroneously effected.

There will now be described an embodiment of this invention with reference to the accompanying drawings.

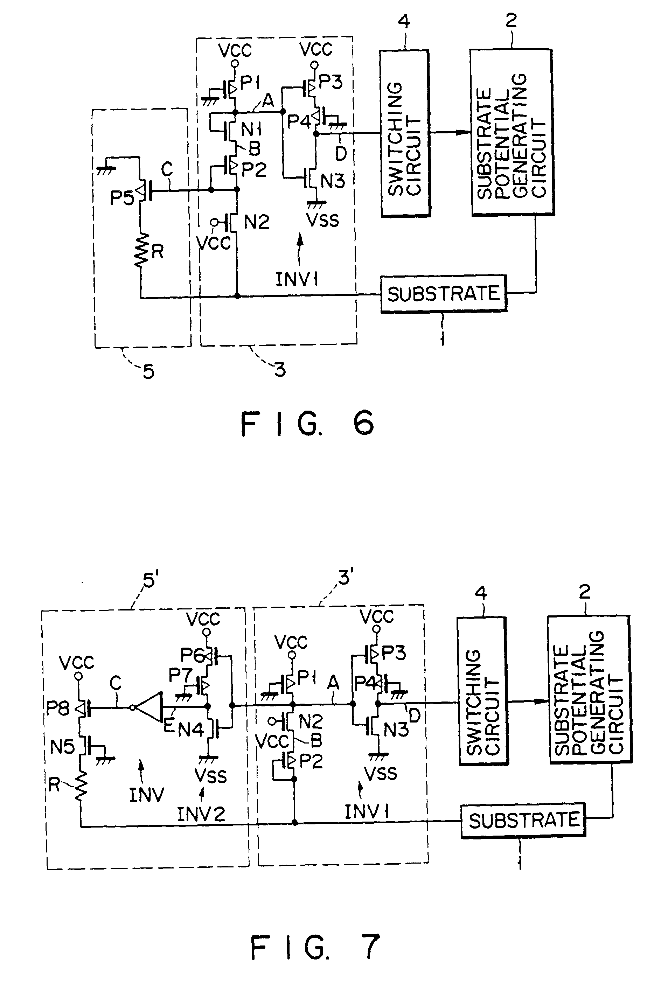

Fig. 6 shows a substrate potential controlling circuit of a semiconductor integrated circuit according to this invention. The substrate potential controlling circuit has a substrate potential controlling function, and includes a substrate potential generating circuit, a substrate potential detection circuit for detecting the substrate potential and a switching circuit for ON-OFF controlling the operation of the substrate potential generating circuit according to the detection output of the substrate potential detection circuit. That is, 1 denotes a substrate, 2 a substrate potential generating circuit for generating a potential of the substrate 1, 3 a substrate potential detection circuit for detecting the potential of the substrate 1, 4 a switching circuit for ON-OFF controlling the operation of the substrate potential generating circuit 2 according to the detection output of the substrate potential detection circuit 3, and 5 a substrate potential leaking circuit. The substrate potential leaking circuit 5 raises the substrate potential by injecting charges into the substrate 1 when the the substrate potential becomes lower than a level (detection level) at which the substrate potential generating circuit 2 can operate by more than a preset voltage in a negative direction and interrupts the operation of injecting charges into the substrate 1 when the substrate potential has reached a preset negative voltage level which is slightly lower than the detection level.

The substrate potential detection circuit 3 has several circuit elements which are series-connected between a Vcc power source node and the substrate 1. That is, the detection circuit 3 includes a first P-channel transistor P1 having a gate connected to a ground potential Vss node, a first N-channel transistor N1 having a drain and a gate connected together, a second P-channel transistor P2 having a gate and a drain connected together, and a second N-channel transistor N2 having a gate connected to the Vcc power source node. The detection circuit 3 further includes several circuit elements series-connected between the Vcc node and the Vss node. That is, the detection circuit 3 includes a third P-channel transistor P3, a fourth P-channel transistor P4 having a gate connected to the Vss node, and a third N-channel transistor N3. With the above construction, the drain (point A) of the first N-channel transistor N1 is connected to the respective gates of the third P-channel transistor P3 and the third N-channel transistor N3. The third P-channel transistor P3, fourth P-channel transistor P4 and third N-channel transistor N3 are combined to constitute a first inverter INV1.

The first P-channel transistor P1 and second N-channel transistor N2 effect the ratio operation to control a through current and determine the substrate potentials for respective power source voltages. The second P-channel transistor P2 is used to set the potential of the source (point B) thereof to 0 V or to a level which is lower than 0 V by a small voltage (ΔV1 which is, for example, 0.1 to 0.2 V) when the potential of the gate (point C) of the fifth P-channel transistor P5 has reached a gate potential Vthp₅ (-0.6 V, for example). The threshold voltage Vthp₂ (negative value) thereof is set to satisfy the following expression:$\left|{\text{Vthp}}_{\text{5}}\right| \text{-} \left|{\text{Vthp}}_{\text{2}}\right| {\text{≃ ΔV}}_{\text{1}} \text{≧ 0 V}$

The first N-channel transistor N1 is used to set the potential of the point B to 0 V or to a level which is higher than 0 V by a small voltage (ΔV2 which is, for example, 0.1 to 0.2 V) when the potential of the drain (point A) thereof is set at the threshold voltage Vth₁ of the first inverter INV1. The threshold voltage Vthn₁ (positive value) is set to satisfy the following expression:${\text{Vth}}_{\text{1}} {\text{- Vthn}}_{\text{1}} {\text{≃ ΔV}}_{\text{2}} \text{≧ 0 V}$

In the semiconductor integrated circuit of this inventions the size of the first N-channel transistor N1 and second P-channel transistor P2 is set larger than that of the first P-channel transistor P1 and second N-channel transistor N2. Therefore, the potential difference between the points A and B is always set to Vthn₁ and the potential difference between the points A and C is always set near |Vthp₂|. Further, the ratio of the size of the third N-channel transistor N3 used as a driving transistor to the total size of the third P-channel transistor P3 and fourth P-channel transistor P4 used as load transistors is set to a large value. With this construction, when the potential of the point A which is an input of the third P-channel transistor P3 and third N-channel transistor N3 has slightly exceeded the threshold voltage Vthn₃ of the third N-channel transistor N3, the potential of an output point (drain of the third N-channel transistor N3) D is immediately set to a low level.

The switching circuit 4 is constructed to set the substrate potential generating circuit 2 operative when the detection output of the output point D of the substrate potential detection circuit 3 is set at a low level, and set the substrate potential generating circuit 2 non-operative when the detection output of of the substrate potential detection circuit 3 is set at a high level.

The substrate potential leak circuit 5 has the fifth P-channel transistor P5 and resistor R serially connected between the Vss node and the substrate. The gate (point C) of the fifth P-channel transistor P5 is connected to the gate and drain of the second P-channel transistor P2 of the substrate potential detection circuit 3. The fifth P-channel transistor P5 is a gate transistor for leaking the substrate potential and is turned on to complete a leak path to the substrate 1 when the substrate potential becomes deeper and lower than the threshold voltage Vthp₅ (negative value) of the fifth P-channel transistor P5. At this time, the following equation can be obtained based on Eqs. (1) and (2):$\text{-} \left|{\text{Vthp}}_{\text{5}}\right| \text{+} \left|{\text{Vthp}}_{\text{2}}\right| {\text{+ Vthn}}_{\text{1}} {\text{= Vth}}_{\text{1}} {\text{- (ΔV}}_{\text{1}} {\text{+ ΔV}}_{\text{2}} \text{)}$

Therefore, the output point D of the substrate potential detection circuit 3 is set to a high potential level and the substrate potential generating circuit 3 is already set non-operative.

The resistor R suppresses the charges from being excessively injected into the substrate 1, but can be omitted if the fifth P-channel transistor P5 can be used to limit the current. When the charges are injected into the substrate 1 by means of the fifth P-channel transistor P5, the substrate potential starts to rise. Then, when the potential of the gate (point C) of the fifth P-channel transistor P5 has reached the threshold voltage Vthp₅ of the fifth P-channel transistor P5, the fifth P-channel transistor P5 is turned off, cutting off the rapid leak path to the substrate 1. After this, the substrate 1 is set into the electrically floating condition and the substrate potential is gradually raised by junction leak or the like, and when the potential of the gate (point C) of the fifth P-channel transistor P5 is set to "-|Vthp₅| + ΔV₁ + ΔV₂", or when the potential of the drain (point A) of the first N-channel transistor N1 is set to the threshold voltage Vth₁ (positive value) of the inverter INV1, the output point D of the substrate potential detection circuit 3 is set to a low level and the operation of the substrate potential generating circuit 2 is started.

As a result, the voltage "ΔV₁ + ΔV₂" is set in a voltage range in which the substrate is set in the electrically floating condition and which is a stable range for the substrate potential to prevent increase in the current consumption. Further, the value can be freely changed by controlling the threshold voltage of the transistor according to the circuit operation margin for the substrate voltage.

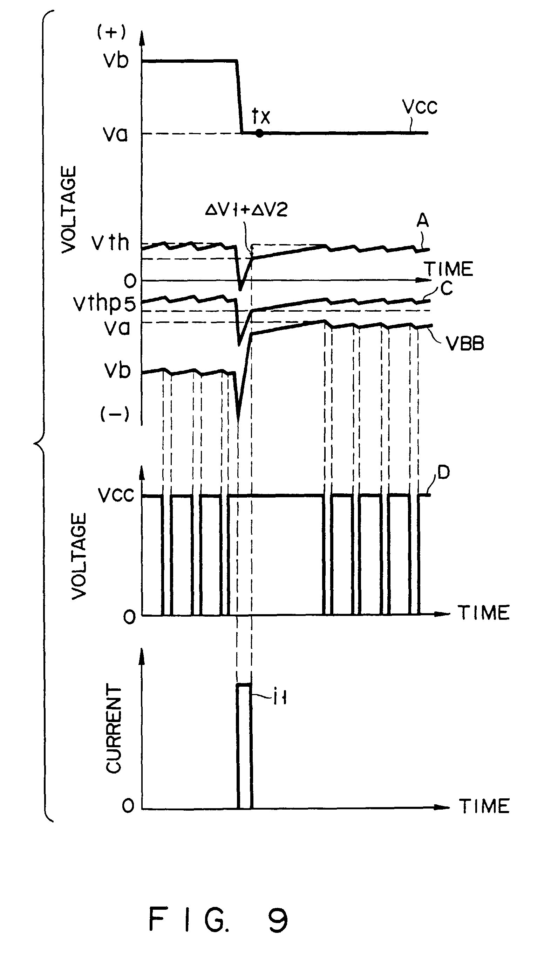

Fig. 9 shows the dependency of the substrate potential on the power source voltage and voltage and current waveforms of respective nodes in the circuit of Fig. 6 when the power source voltage drop as shown in Fig. 3B has occurred.

Fig. 7 shows another embodiment which is similar to the former embodiment except a substrate potential detection circuit 3′ and a substrate potential leak circuit 5′. The substrate potential detection circuit 3′ is similar to the substrate potential detection circuit 3 except that the first N-channel transistor N1 is omitted and the second P-channel transistor P2 is positioned on the source side of the second N-channel transistor N2. However, the operation of the substrate potential detection circuit 3′ is substantially the same as that of the substrate potential detection circuit 3.

In the substrate potential leak circuit 5′, a sixth P-channel transistor P6, a seventh P-channel transistor P7 whose gate is connected to a Vss node and a fourth N-channel transistor N4 are series-connected between the Vcc node and Vss node, and the drain (point A) of the second N-channel transistor N2 is connected to the gates of the sixth P-channel transistor P6 and fourth N-channel transistor N4. The sixth P-channel transistor P6, seventh P-channel transistor P7 and fourth N-channel transistor N4 are combined to constitute a second inverter INV2.

An eighth P-channel transistor P8 used as a gate transistor, a fifth N-channel transistor N5 whose gate is connected to the Vss node and a resistor R are series-connected between the Vcc node and substrate 1, and these elements are combined to constitute a substrate potential leak path section. The input terminal of a third inverter INV3 is connected to the drain (point E) of the fourth N-channel transistor N4 and the output terminal (point C) of the inverter INV3 is connected to the gate of the eighth P-channel transistor P8.

In the substrate potential leak circuit 5′, the threshold voltage Vth₂ of the second inverter INV2 is set to be slightly lower than the threshold voltage Vth₁ of the first inverter INV1 of the substrate potential detection circuit 3′. The difference between the threshold voltages of the inverters INV1 and INV2 defines a voltage range in which the substrate 1 is substantially kept in the electrically floating condition from when the eighth P-channel transistor P8 of the substrate potential leak path section is cut off until the operation of the substrate potential generating circuit is started. When the substrate potential becomes deeper and the potential of the point A becomes lower than the threshold voltage Vth₂ of the second inverter INV2, the potential of the point E rises and the output potential of the third inverter INV3 is lowered.

Assuming that the absolute value of the threshold voltage Vthp₈ (negative value) of the eighth P-channel transistor P8 is expressed by |Vthp₈|, then the eighth P-channel transistor P8 is turned on to create a leak path to the substrate 1 when the output potential of the third inverter INV3 becomes lower than "Vcc - |Vthp₈|". At this time, the fifth N-channel transistor N5 acts as a limiter for holding the substrate potential at least to "Vss-Vthn₅" when the threshold voltage (positive value) of the fifth N-channel transistor N5 is expressed by "Vthn₅". Further, at this time, the resistor R which functions to suppress the charges from being excessively injected into the substrate 1 can be omitted if a current limiting function can be attained by the eighth P-channel transistor P8 and the fifth N-channel transistor N5. In this case, the output point D of the substrate potential detection circuit 3′ is set at a high level and the substrate potential generating circuit 2 is already set non-operative.

When the substrate potential is set to a shallow level by the above leak, the potential of the point A rises and first exceeds the threshold voltage Vth₂ of the second inverter INV2. As a result, the second inverter INV2 effects the inverting operation to lower the potential of the point E and the output potential of the third inverter INV3 rises. When the output potential of the third inverter INV3 has reached "Vcc - |Vthp₈|", the eighth P-channel transistor P8 is turned off, thereby cutting off the rapid leak path to the substrate 1. At this time, since the potential of the point A has not exceeded the threshold voltage Vth₁ of the first inverter INV1, the substrate potential generating circuit 2 is still kept non-operative. After this, the substrate 1 is set into the electrically floating condition, the substrate potential is gradually raised by junction leak or the like, the potential of the point A exceeds the threshold voltage Vth₁ of the first inverter INV1, and the substrate potential generating circuit 2 is operated to set or pull back the substrate potential to the preset level.

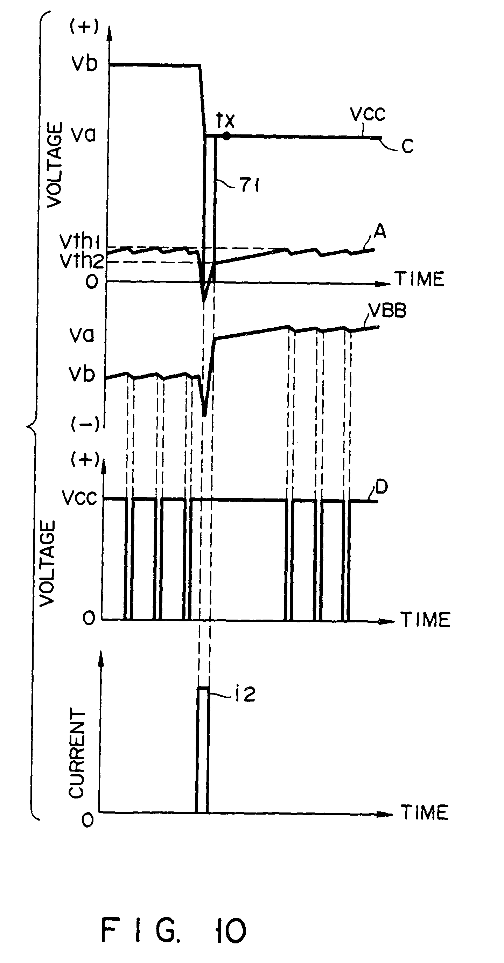

Fig. 10 shows the dependency of the substrate potential on the power source voltage and voltage and current waveforms of respective nodes in the circuit of Fig. 7 when the power source voltage drop as shown in Fig. 3B has occurred.

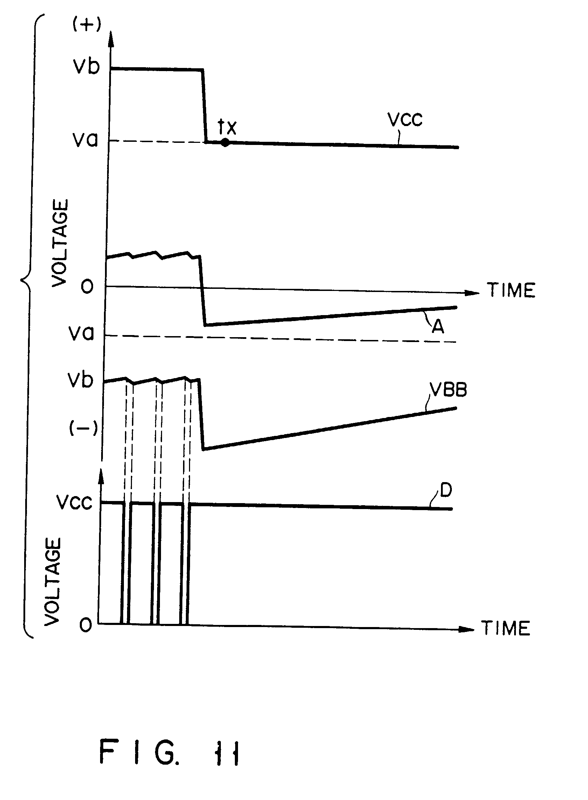

Fig. 11 shows the dependency of the substrate potential on the power source voltage and voltage and current waveforms of respective nodes in the conventional circuit (corresponding to a circuit obtained by removing the substrate potential leak circuit 5′ from the circuit of Fig. 7) when the power source voltage drop as shown in Fig. 3B has occurred.

In a case where the power source voltage is generally kept constant, the substrate power source V_{BB} is repeatedly subjected to the pull-back effect by the substrate potential generating circuit 2 and leak. Since it takes a certain period of time to effect the operation of the substrate potential generating circuit 2 and switching circuit 4, the substrate potential takes the sawtooth waveform. However, the voltage range of the sawtooth waveform is small and does not vary so much as to operate the substrate potential leak circuit 5 or 5′, thereby keeping the current consumption small.

Further, in order to ensure that the substrate potential leak circuit 5′ can be kept in the non-operative condition while the substrate potential generating circuit 2 is operated, it is possible to feed back the output of the switching circuit 4 to the leak circuit 5′ so as to logically set the leak circuit 5′ non-operative while the substrate potential generating circuit 2 is operated.

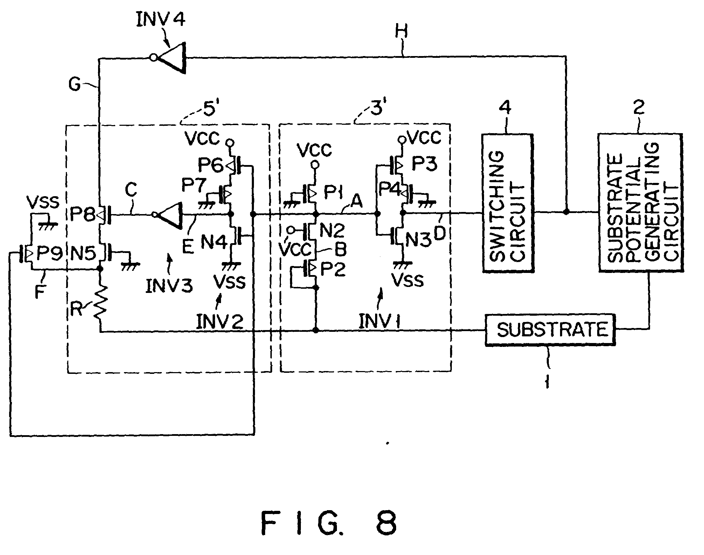

One example is shown in Fig. 8 using an inverter INV4, and the inverter INV4 receives the potential of the output node (point H) of the switching circuit 4 in a case where the substrate potential generating circuit 2 is operated when the output of the switching circuit 4 is held at an "H" level and the output node (point G) of the inverter INV4 is connected to the source of the eighth P-channel transistor P8 as a leak source instead of the Vcc node of the leak circuit 5′. In this circuit, the output of the switching circuit 4 is kept at the "H" level and the potential of the output node (point G) of the inverter INV4 is set to an "L" level while the substrate potential generating circuit 2 is operated. In this case, even if the potential of the point C is set to the "L" level, the leak circuit 5′ will not be set into the operative condition. The feedback circuit may be any type of circuit if it sets the potential of the point G to the "L" level while the substrate potential generating circuit 2 is operated.

As can be understood by comparing Figs. 9 to 11 with one another, a leak current starts to abruptly flow in response to the power source voltage drop when the potential of point C becomes lower than the threshold voltage Vthp₅ (negative value) of the fifth P-channel transistor P5 in a case shown in Fig. 9 and when the potential of point A exceeds the threshold voltage Vth₂ of the second inverter INV2 in Fig. 10, thus rapidly restoring the substrate potential. In contrast, in a case shown in Fig. 11, it takes a long time to restore the substrate potential. In this case, i₁ denotes a current flowing in the substrate potential leak circuit 5 and i₂ denotes a current flowing in the substrate potential leak circuit 5′.

It will be easily understood by considering the operation at the time tx immediately after the power source voltage drop that the circuit of this invention has a remarkably improved effect in comparison with the conventional circuit. The improved effect can also be obtained when the power source voltage is once set to the OFF level and is then raised immediately after this as shown in Fig. 3. In the case of the circuit shown in Fig. 6, the substrate potential leaks to a level near the threshold voltage Vthp₅ (negative value) of the fifth P-channel transistor P5 while the power source voltage is set at the OFF level. On the other hand, in the case of the circuits shown in Figs. 7 and 8, the substrate potential does not leak while the power source voltage is set at the OFF level, and it is restored to a substrate potential level corresponding to the power source voltage immediately after the power source voltage is set to the ON level again.

In the circuit of Fig. 7, in order to attain the same dependency of the substrate potential V_{BB} on the Vcc potential OFF-time as that in the circuit of Fig. 6, a ninth P-channel transistor P9 whose source, gate and drain are respectively connected to the Vss node, point A and the source (point A) of the fifth N-channel transistor N5 may be additionally used as shown in Fig. 8. In this case, however, the level to which the substrate potential V_{BB} is pulled back during the Vcc potential OFF-time may be set near "Vthp₂ + Vthp₉". Vthp₂ is the threshold voltage of the second P-channel transistor P2 and Vthp₉ is the threshold voltage of the ninth P-channel transistor P9.

Further, when the power source voltage has risen as shown in Fig. 3A, the substrate potential detection circuit 3 is made operative in the same manner as in the conventional case so that the substrate potential generating circuit 3 can be operated to lower the substrate potential to a level corresponding to the power source voltage and therefore there occurs no special problem.

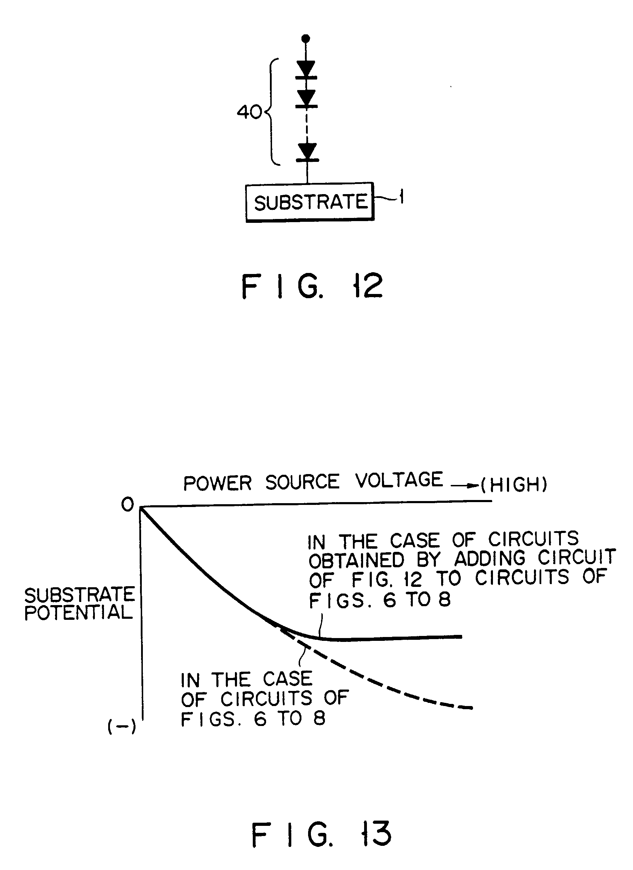

It is possible to change the dependency of the substrate potential on the power source voltage as indicated by the solid line in Fig. 13 by connecting one end of the diode circuit 40 or the like shown in Fig. 12 to the point B of the substrate potential detection circuit 3 or to the point A of the substrate potential detection circuit 3′ of Fig. 7 or 8. In this case, it is possible to attain the same effect as described in each of the former embodiments.

As described above, according to the substrate potential controlling circuit of the semiconductor integrated circuit of this invention, the substrate potential detection circuit is commonly used to set the substrate potential generating circuit into the operative condition when the substrate potential becomes higher than a preset level and set the substrate potential leak circuit into the operative condition when the substrate potential becomes lower than a preset level so that the ability of the substrate potential to follow variations in the power source voltage can be enhanced without increasing the current consumption. Further, the substrate potential detection circuit is commonly used, the substrate potential set after the pull-back operation can be precisely determined without receiving influence by variation of the properties of elements.

Reference signs in the claims are intended for better understanding and shall not limit the scope.

## Claims

1. A semiconductor integrated circuit having a substrate potential control function and comprising: a substrate potential generating circuit (2); a substrate potential detection circuit (3, 3') for sensing a substrate potential; a switch circuit (4) for turning on or off the substrate potential generating circuit on the basis of a detection output of the substrate potential detection circuit; and a substrate potential leak circuit (5, 5'),
**characterized** in that said substrate potential leak circuit (5, 5') supplies charges into the substrate (1) to raise the substrate potential when the substrate potential becomes lower than an operating level of the substrate potential generating circuit (2) by a predetermined voltage, and stops supplying the charges into the substrate (1) when the substrate potential becomes slightly lower than the operating level of the substrate potential generating circuit (2); and
said substrate potential leak circuit (5, 5') includes a P-channel transistor (P5, P8) having a gate controlled in accordance with an output of the substrate potential detection circuit (3, 3'), said P-channel transistor having a current path whose one end is connected to a leak source used for raising the substrate potential.

2. A semiconductor integrated circuit according to claim 1,
**characterized** in that said substrate potential leak circuit (5') further includes inverter means (INV3) for shaping a waveform of an output of the substrate potential detection cicuit (3'), the gate of the P-channel transistor (P8) being controlled in accordance with an output of the inverter means (INV3).

3. A semiconductor integrated circuit according to claim 1 or 2,
**characterized** in that said substrate potential leak (5') further includes
a N-channel transistor (N5) having a gate connected to a ground-potential node, said N-channel transistor (N5) having a current path inserted between the substrate (1) and another end of the current path of the first P-channel transistor (P8).

4. A semiconductor integrated circuit according to any one of claims 1 to 3,
**characterized** by further comprising means (INV4) for supplying an output of the switch circuit (4) to the substrate potential leak circuit (5') as said leak source of a leak path, said substrate potential leak circuit (5') being turned off when the substrate potential leak circuit receives the output of the switch circuit (4) in a state where the substrate potential generating circuit (2) is kept on by the output of the leak circuit.

5. A semiconductor integrated circuit according to any one of claims 1 to 4,
**characterized** in that a resisotr (R) for restricting supply of charges is inserted between the substrate (1) and one end of the current path of the N-channel transistor (N5) or the P-channel transistor (P5).

6. A semiconductor integrated circuit according to claim 5,
**characterized** by further comprising a further P-channel transistor (P9) having a gate controlled in accordance with an output of the substrate potential detection circuit (3'), said second P-channel transistor (P9) having a current path inserted between the ground-potential node and a point at which the resistor (R) and said one end of the current path of the N-channel transistor (N5) are connected together.

7. A semiconductor integrated circuit according to claim 1,
**characterized** in that said substrate potential detection circuit (3) includes a first P-channel transistor (P1) having a gate connected to a ground potential node, a first N-channel transistor (N1) having a gate and a drain connected together, a second P-channel transistor (P2) having a gate and a drain connected together, and a second N-channel transistor (N2) having a gate connected to a power source node, said transistors (N1, N2, P1, P2) being series-connected between said power source node and said substrate (1), and further includes a third P-channel transistor (P3) having a gate connected to the drain of said first P-channel transistor (P1) and a source connected to said power source node, a fourth P-channel transistor (P4) having a gate connected to a ground potential node, and a third N-channel transistor (N3) having a gate connected to the drain of said first P-channel transistor (P1) and a source connected to said ground potential node, said third and fourth transistors (P3, P4, N3) being series-connected between said power source node and said ground potential node.

8. A semiconductor integrated circuit according to claim 7,
**characterized** in that the size of said first N-channel transistor (N1) and said second P-channel transistor (P2) is set to be larger than that of said first P-channel transistor (P1) and said second N-channel transistor (N2).

9. A semiconductor integrated circuit according to claim 7,
**characterized** by further comprising a diode (40) connected to the source of said first N-channel transistor (N1).

10. A semiconductor integrated circuit according to claim 1,
**characterized** in that said substrate potential detection circuit (3') includes a first P-channel transistor (P1) having a gate connected to a ground potential node, a second P-channel transistor (P2) having a gate and a drain connected together, and a second N-channel transistor (N2) having a gate connected to a power source node, said transistors (P1, P2, N2) being series-connected between said power source node and said substrate (1), and further includes a third P-channel transistor (P3) having a gate connected to the drain of said first P-channel transistor (P1) and a source connected to said power source node, a fourth P-channel transistor (P4) having a gate connected to said ground potential node, and a third N-channel transistor (N3) having a gate connected to the drain of said first P-channel transistor (P1) and a source connected to said ground potential node, said third and fourth transistors (P3, P4, N3) being series-connected between said power source node and said ground potential node.

11. A semiconductor integrated circuit according to claim 10,
**characterized** by further comprising a diode (40) connected to the drain of said first P-channel transistor (P1).

12. A semiconductor integrated circuit according to claim 4,
**characterized** in that said suppplying means (INV4) includes an inverter circuit.

13. A semiconductor integrated circuit according to claim 3,
**characterized** in that said substrate potential leak circuit (5') includes a sixth P-channel transistor (P6), a seventh P-channel transistor (P7) having a gate connected to a ground potential node, and a fourth N-channel transistor (N4), said transistors (P6, P7, N4) being series-connected between a power source node and said ground potential node.

## Patentansprüche

1. Integrierte Halbleiterschaltung, die eine Substratpotential-Steuerfunktion aufweist und umfaßt: eine Substratpotential-Erzeugungsschaltung (2); eine Substratpotential-Erfassungsschaltung (3, 3') zum Erfassen eines Substratpotentials; eine Schalt-Schaltung (4) zum EIN- oder AUS-Schalten der Substratpotential-Erzeugungsschaltung auf Grundlage eines Erfassungsausgangs der Substratpotential-Erfassungsschaltung; und eine Substratpotential-Leckschaltung (5, 5'),
**dadurch gekennzeichnet,** daß
die Substratpotential-Leckschaltung (5, 5') Ladungen in das Substrat (1) hinein zuführt, um das Substratpotential anzuheben, wenn das Substratpotential um eine vorgegebene Spannung kleiner als ein Betriebspegel der Substratpotential-Erzeugungsschaltung (2) wird, und eine Zuführung der Ladungen in das Substrat (1) hinein stoppt, wenn das Substratpotential geringfügig kleiner als der Betriebspegel der Substratpotential-Erzeugungsschaltung (2) wird; und
die Substratpotential-Leckschaltung (5, 5') einen P-Kanal-Transistor (P5, P8) mit einem Gate umfaßt, das gemäß einem Ausgang der Substratpotential-Erzeugungsschaltung (3, 3') gesteuert wird, wobei der P-Kanal-Transistor einen Strompfad aufweist, dessen eines Ende mit einer Leckquelle verbunden ist, die zum Anheben des Substratpotentials verwendet wird.

2. Integrierte Halbleiterschaltung nach Anspruch 1, dadurch gekennzeichnet, daß die Substratpotential-Leckschaltung (5') ferner eine Invertereinrichtung (INV3) zum Formen einer Wellenform eines Ausgangs der Substratpotential-Erfassungsschaltung (3') umfaßt, wobei das Gate des P-Kanal-Transistors (P8) gemäß einem Ausgang der Invertereinrichtung (INV3) gesteuert wird.

3. Integrierte Halbleiterschaltung nach Anspruch 1 oder 2, dadurch gekennzeichnet, daß das Substratpotential-Leck (5') ferner umfaßt:
einen N-Kanal-Transistor (N5) mit einem Gate, das mit einem Massepotentialknoten verbunden ist, wobei der N-Kanal-Transistor (N5) einen Strompfad aufweist, der zwischen das Substrat (1) und ein anderes Ende des Strompfads des ersten P-Kanal-Transistors (P8) eingefügt ist.

4. Integrierte Halbleiterschaltung nach einem der Ansprüche 1 bis 3, dadurch gekennzeichnet, daß sie ferner umfaßt: eine Einrichtung (INV4) zum Zuführen eines Ausgangs der Schalt-Schaltung (4) an die Substratpotential-Leckschaltung (5') als die Leckquelle eines Leckpfads, wobei die Substratpotential-Leckschaltung (5') ausgeschaltet wird, wenn die Substratpotential-Leckschaltung den Ausgang der Schalt-Schaltung (4) in einem Zustand empfängt, in dem die Substratpotential-Erzeugungsschaltung (2) durch den Ausgang der Leckschaltung eingeschaltet gehalten wird.

5. Integrierte Halbleiterschaltung nach einem der Ansprüche 1 bis 4, dadurch gekennzeichnet, daß ein Widerstand (R) zum Begrenzen einer Zuführung von Ladungen zwischen das Substrat (1) und ein Ende des Strompfads des N-Kanal-Transistors (N5) oder des P-Kanal-Transistors (P5) eingefügt ist.

6. Integrierte Halbleiterschaltung nach Anspruch 5, dadurch gekennzeichnet, daß sie ferner umfaßt: einen weiteren P-Kanal-Transistor (P9) mit einem Gate, das gemäß einem Ausgang der Substratpotential-Erfassungsschaltung (3') gesteuert wird, wobei der zweite P-Kanal-Transistor (P9) einen Strompfad aufweist, der zwischen den Massepotentialknoten und einen Punkt eingefügt ist, an dem der Widerstand (R) und das eine Ende des Strompfads des N-Kanal-Transistors (N5) zusammengeschaltet sind.

7. Integrierte Halbleiterschaltung nach Anspruch 1, dadurch gekennzeichnet, daß die Substratpotential-Erfassungsschaltung (3) umfaßt: einen ersten P-Kanal-Transistor (P1) mit einem Gate, das mit einem Massepotentialknoten verbunden ist, einen ersten N-Kanal-Transistor (N1) mit einem Gate und einer Drain, die zusammengeschaltet sind, einen zweiten P-Kanal-Transistor (P2) mit einem Gate und einer Drain, die zusammengeschaltet sind, und einen zweiten N-Kanal-Transistor (N2) mit einem Gate, das mit einem Energiequellenknoten verbunden ist, wobei die Transistoren (N1, N2, P1, P2) zwischen den Energiequellenknoten und das Substrat (1) in Reihe geschaltet sind, und ferner umfaßt: einen dritten P-Kanal-Transistor (P3) mit einem mit der Drain des ersten P-Kanal-Transistors (P1) verbundenen Gate und einer mit dem Energiequellenknoten verbundenen Source, einem vierten P-Kanal-Transistor (P4) mit einem Gate, das mit einem Massepotentialknoten verbunden ist, und einen dritten N-Kanal-Transistor (N3) mit einem Gate, das mit der Drain des ersten P-Kanal-Transistors (P1) verbunden ist, und mit einer Source, die mit dem Massepotentialknoten verbunden ist, wobei die dritten und vierten Transistoren (P3, P4, N3) zwischen den Energiequellenknoten und den Massepotentialknoten in Reihe geschaltet sind.

8. Integrierte Halbleiterschaltung nach Anspruch 7, dadurch gekennzeichnet, daß die Größe des ersten N-Kanal-Transistors (N1) und des zweiten P-Kanal-Transistors (P2) größer eingestellt ist als diejenige des ersten P-Kanal-Transistors (P1) und des zweiten N-Kanal-Transistors (N2).

9. Integrierte Halbleiterschaltung nach Anspruch 7, dadurch gekennzeichnet, daß sie ferner umfaßt: eine Diode (40), die mit der Source des ersten N-Kanal-Transistors (N1) verbunden ist.

10. Integrierte Halbleiterschaltung nach Anspruch 1, dadurch gekennzeichnet, daß die Substratpotential-Erfassungsschaltung (3') umfaßt: einen ersten P-Kanal-Transistor (P1) mit einem Gate, das mit einem Massepotentialknoten verbunden ist, einen zweiten P-Kanal-Transistor (P2) mit einem Gate und einer Drain, die zusammengeschaltet sind, und einen zweiten N-Kanal-Transistor (N2) mit einem Gate, das mit einem Energiequellenknoten verbunden ist, wobei die Transistoren (P1, P2, N2) zwischen den Energiequellenknoten und das Substrat (1) in Reihe geschaltet sind, und ferner umfaßt: einen dritten P-Kanal-Transistor (P3) mit einem Gate, das mit der Drain des ersten P-Kanal-Transistors (P1) verbunden ist, und mit einer Source, die mit dem Energiequellenknoten verbunden ist, einen vierten P-Kanal-Transistor (P4) mit einem Gate, das mit dem Massepotentialknoten verbunden ist, und einen dritten N-Kanal-Transistor (N3) mit einem Gate, das mit der Drain des ersten P-Kanal-Transistors (P1) verbunden ist, und mit einer Source, die mit dem Massepotentialknoten verbunden ist, wobei die dritten und vierten Transistoren (P3, P4, N3) zwischen den Energiequellenknoten und den Massepotentialknoten in Reihe geschaltet sind.

11. Integrierte Halbleiterschaltung nach Anspruch 10, dadurch gekennzeichnet, daß sie ferner umfaßt: eine Diode (40), die mit der Drain des ersten P-Kanal-Transistors (P1) verbunden ist.

12. Integrierte Halbleiterschaltung nach Anspruch 4, dadurch gekennzeichnet, daß die Zuführungseinrichtung (INV4) eine Inverterschaltung umfaßt.

13. Integrierte Halbleiterschaltung nach Anspruch 3, dadurch gekennzeichnet, daß die Substratpotential-Leckschaltung (5') umfaßt: einen sechsten P-Kanal-Transistor (P6), einen siebten P-Kanal-Transistor (P7) mit einem Gate, das mit einem Massepotentialknoten verbunden ist, und einen vierten N-Kanal-Transistor (N4), wobei die Transistoren (P6, P7, N4) zwischen einen Energiequellenknoten und den Massepotentialknoten in Reihe geschaltet sind.

## Revendications

1. Circuit intégré à semiconducteur ayant une fonction de commande du potentiel du substrat et comprenant: un circuit générateur de potentiel du substrat (2); un circuit de détection du potentiel du substrat (3, 3') pour détecter le potentiel du substrat; un circuit de commutation (4) pour mettre en circuit ou hors circuit le circuit générateur de potentiel du substrat sur la base du signal de sortie de détection du circuit de détection du potentiel du substrat; et un circuit de fuite du potentiel du substrat (5, 5'),
caractérisé en ce que ledit circuit de fuite du potentiel du substrat (5, 5') fournit des charges au substrat (1) pour élever le potentiel du substrat lorsque le potentiel du substrat devient inférieur à un niveau de fonctionnement du circuit générateur de potentiel du substrat (2) de la valeur d'une tension prédéterminée et arrête de fournir les charges au substrat (1) lorsque le potentiel du substrat devient légèrement inférieur au niveau de fonctionnement du circuit générateur de potentiel du substrat (2); et
- ledit circuit de fuite du potentiel du substrat (5, 5') comporte un transistor à canal P (P5, P8) ayant une grille commandée selon le signal de sortie du circuit de détection du potentiel du substrat (3, 3'), ledit transistor à canal P ayant un chemin de courant dont une extrémité est connectée à une source de courant de fuite utilisée pour élever le potentiel du substrat.

2. Circuit intégré à semiconducteur selon la revendication 1,
caractérisé en ce que ledit circuit de fuite du potentiel du substrat (5') comprend en outre des moyens formant inverseur (INV3) pour mettre en forme la forme d'onde du signal de sortie du circuit de détection du potentiel du substrat (3'), la grille du transistor à canal P (P8) étant commandée selon le signal de sortie des moyens formant inverseur (INV3).

3. Circuit intégré à semiconducteur selon la revendication 1 ou 2,
caractérisé en ce que ledit circuit de fuite du potentiel du substrat (5') comprend en outre:
- un transistor à canal N (N5) ayant une grille connectée à un noeud au potentiel de la masse, ledit transistor à canal N (N5) ayant un chemin de courant inséré entre le substrat (1) et l'autre extrémité du chemin de courant du premier transistor à canal P (P8).

4. Circuit intégré à semiconducteur selon l'une quelconque des revendications 1 à 3,
caractérisé en ce qu'il comprend en outre des moyens (INV4) pour fournir le signal de sortie du circuit de commutation (4) au circuit de fuite du potentiel du substrat (5') comme étant ladite source de courant de fuite d'un chemin de fuite, ledit circuit de fuite du potentiel du substrat (5') étant ouvert lorsque le circuit de fuite du potentiel du substrat reçoit le signal de sortie du circuit de commutation (4) dans un état où le circuit générateur de potentiel du substrat (2) est maintenu en action par le signal de sortie du circuit de fuite.

5. Circuit intégré à semiconducteur selon l'une quelconque des revendications 1 à 4,
caractérisé en ce qu'une résistance (R) prévue pour limiter la fourniture de charges est insérée entre le substrat (1) et une extrémité du chemin de courant du transistor à canal N (N5) ou du transistor à canal P (P5).

6. Circuit intégré à semiconducteur selon la revendication 5,
caractérisé en ce qu'il comprend en outre un autre transistor à canal P (P9) ayant une grille commandée selon le signal de sortie du circuit de détection du potentiel du substrat (3'), ledit deuxième transistor à canal P (P9) ayant un chemin de courant inséré entre un noeud au potentiel de la masse et un point auquel la résistance R et ladite une extrémité du chemin de courant du transistor à canal N (N5) sont connectés ensemble.

7. Circuit intégré à semiconducteur selon la revendication 1,
caractérisé en ce que ledit circuit de détection du potentiel du substrat (3) comprend un premier transistor à canal P (P1) ayant une grille connectée à un noeud au potentiel de la masse, un premier transistor à canal N (N1) ayant une grille et un drain connectés ensemble, un deuxième transistor à canal P (P2) ayant une grille et un drain connectés ensemble, et un deuxième transistor à canal N (N2) ayant une grille connectée à un noeud de source d'énergie, lesdits transistors (N1, N2,P1, P2) étant montés en série entre ledit noeud de source d'énergie et ledit substrat (1), et comprend en outre un troisième transistor à canal P (P3) ayant une grille connectée au drain dudit premier transistor à canal P (P1) et une source connectée audit noeud de source d'énergie, un quatrième transistor à canal P (P4) ayant une grille connectée à un noeud au potentiel de la masse, et un troisième transistor à canal N (N3) ayant une grille connectée au drain dudit premier transistor à canal P (P1) et une source connectée audit noeud au potentiel de la masse, lesdits troisièmes et quatrième transistors (P3, P4, N3) étant montés en série entre ledit noeud de source d'énergie et ledit noeud au potentiel de la masse.

8. Circuit intégré à semiconducteur selon la revendication 7,
caractérisé en ce que la taille dudit premier transistor à canal N (N1) et dudit deuxième transistor à canal P (P2) est établie pour être plus grande que celle dudit premier transistro à canal P (P1) et dudit deuxième transistor à canal N (N2).

9. Circuit intégré à semiconducteur selon la revendication 7,
caractérisé en ce qu'il comprend en outre une diode (40) connectée à la source dudit premier transistor à canl N (N1).

10. Circuit intégré à semiconducteur selon la revendication 1,
caractérisé en ce que ledit circuit de détection du potentiel du substrat (3') comprend un premier transistor à canal P (P1) ayant une grille connectée à un noeud au potentiel de la masse, un deuxième transistor à canal P (P2) ayant une grille et un drain connectés ensemble, et un deuxième transistor à canal N (N2) ayant une grille connectée à un noeud de source d'énergie, lesdits transistors (P1, P2, N2) étant montés en série entre ledit noeud de source d'énergie et ledit substrat (1), et comprend en outre un troisième transistor à canal P (P3) ayant une grille connectée au drain dudit premier transistor à canl P (P1) et une source connectée audit noeud de source d'énergie, un quatrième transistor à canal P (P4) ayant une grille connectée audit noeud au potentiel de la masse, et un troisième transistor à canal N (N3) ayant une grille connectée au drain dudit premier transistor à canal P (P1) et une source connectée audit noeud au potentiel de la masse, lesdits troisièmes et quatrième transistors (P3, P4, N3) étant montés en série entre ledit noeud de source d'énergie et ledit noeud au potentiel de la masse.

11. Circuit intégré à semiconducteur selon la revendication 10,
caractérisé en ce qu'il comprend en outre une diode (40) connectée au drain dudit premier transistor à canal P (P1).

12. Circuit intégré à semiconducteur selon la revendication 4,
caractérisé en ce que lesdits moyens fournissant (INV4) comprennent un circuit inverseur.

13. Circuit intégré à semiconducteur selon la revendication 3, caractérisé en ce que ledit circuit de fuite du potentiel du substrat (5') comprend un sixième transistor à canal P (P6), un septième transistor à canal P (P7) ayant une grille connectée à un noeud au potentiel de la masse, et un quatrième transistor à canal N (N4), lesdits transistors (P6, P7, N4) étant montés en série entre un noeud de source d'énergie et ledit noeud au potentiel de la masse.
